# EUROPÄISCHE PATENTSCHRIFT

(11) **EP 4 441 513 B1**
(45) Veröffentlichungstag und Bekanntmachung des Hinweises auf die Patenterteilung: **07.10.2026**
(21) Anmeldenummer: 22826697.9
(22) Anmeldetag: 30.11.2022
(51) Int. Cl.: G01R 31/08, H02H 3/16

(54) **VERFAHREN UND EINRICHTUNG ZUR ISOLATIONSÜBERWACHUNG UND ISOLATIONSFEHLERSUCHE FÜR UNGEERDETE STROMVERSORGUNGSNETZE**
METHOD AND DEVICE FOR INSULATION MONITORING, AND INSULATION FAULT LOCATION FOR UNEARTHED POWER SUPPLY SYSTEMS
PROCÉDÉ ET DISPOSITIF DE SURVEILLANCE D'ISOLATION, ET EMPLACEMENT DE DÉFAUT D'ISOLATION POUR SYSTÈMES D'ALIMENTATION ÉLECTRIQUE NON MIS À LA TERRE

(30) Priorität: 01.12.2021 DE 102021131702
(43) Veröffentlichungstag der Anmeldung: 09.10.2024
(73) Patentinhaber: ESA Elektroschaltanlagen Grimma GmbH, 04668 Grimma (DE)
(72) Erfinder: RATHSMANN, Stephan, 14482 Potsdam (DE)
(74) Vertreter: Dr. Völger, Wolfgang
(86) Internationale Anmeldenummer: PCT/IB2022/061571
(87) Internationale Veröffentlichungsnummer: WO 2023/100088

(56) Entgegenhaltungen:
- EP-A1- 3 413 062
- EP-A1- 3 923 010
- DE-A1- 102005 054 544
- DE-B3- 102017 217 473
- DE-U1- 202004 006 164

## Beschreibung

Die Erfindung betrifft ein Verfahren und eine Einrichtung zur Isolationsüberwachung mit Isolationsüberwachungsgerät und Isolationsfehlersuche ohne Prüfstromgenerator für ungeerdete elektrische Stromversorgungsnetze, die ein Gleich- oder Wechselspannungsnetz sein können.

In ungeerdeten Stromversorgungsnetzen werden Isolationsüberwachungsgeräte (IMD) eingesetzt. Diese Geräte ermitteln den Isolationswiderstand Rᵢₛₒ des Stromversorgungsnetzes zwischen allen Netzleitern und Erde (PE). Wird ein Isolationswiderstand-Ansprechwert Rₐₙ unterschritten, detektiert das Isolationsüberwachungsgerät einen Isolationsfehler des Versorgungsnetzes in Form einer Fehlermeldung. Dieser erste Isolationsfehler sollte nun möglichst schnell beseitigt werden, denn ein zweiter Isolationsfehler kann zum Auslösen von Sicherungen und damit zum Versorgungsausfall sowie Verlust der Schutzmaßnahmen führen.

Durch das Isolationsfehlersuchsystem soll die Fehlerbeseitigung beschleunigt werden, indem schnell der fehlerhafte Netzabgang lokalisiert wird. Derzeitige Isolationsfehlersuchsysteme bestehen aus einen Prüfstromgenerator in Trafonähe und Isolationsfehlersuchgeräten mit Prüfstromsensoren in den Netzabgängen zur Erfassung des durch den Prüfstromgenerator erzeugten Prüfstromes. Das Isolationsfehlersuchsystem startet, wenn das Isolationsüberwachungsgerät einen Isolationsfehler meldet. Der Prüfstromgenerator erzeugt eine Prüfspannung und speist einen Prüfstrom zwischen Netzleiter und Erde (PE) in das Versorgungsnetz ein. Über den Isolationsfehler schließt sich der Prüfstromkreis. Das Isolationsfehlersuchgerät (IFS) erkennt, in welchem Netzabgang der Prüfstrom fließt und meldet den Fehler entsprechend.

Bei Isolationsüberwachung und Isolationsfehlersuche handelt es sich im Stand der Technik um zwei getrennte Prozesse. Der Prüfstromgenerator des Suchsystems darf erst dann aktiviert werden, wenn ein Isolationsfehler im Stromversorgungsnetz vorhanden ist. Andernfalls bildet sich zwischen Stromversorgungsnetz und Erde (PE) eine unzulässig hohe Prüfspannung (U_{L}) aus. Das liegt am Aufbau der Prüfstromgeneratoren. In der Regel enthalten sie eine Konstant-Stromquelle zur Erzeugung des Prüfstromes (I_{L}). Die Stromquelle wird aus der Netzspannung selbst versorgt. Die maximale Prüfspannung bzw. Leerlaufspannung des Prüfstromgenerators entspricht demnach dem Scheitelwert der Netzspannung. Liegt ein Isolationsfehler im Stromversorgungsnetz vor, arbeitet der Prüfstromgenerator nicht mehr im Leerlauf. Es stellt sich eine Prüfspannung von U_{L} = Rᵢₛₒ * I_{L} ein.

Bei einem Isolationsüberwachungsgerät besteht dagegen nicht die Gefahr einer zu hohen Prüf- bzw. Messspannung (Uₘ). Diese Geräte verwenden eine KonstantSpannungsquelle mit U_{q} ≤ 25 V, die über Ankoppelwiderstände (Rᵢ) mit den Netzleitern verbunden ist. Die maximale Messspannung (U_{m,max}) zwischen Stromversorgungsnetz und Erde (PE) ist immer U_{m,max} ≤ U_{q}. Aufgrund dieser Konstruktion ist aber der Messstrom in einem Netzabgang mit Iₘ ≤ U_{q} / Rᵢ so klein, dass er vom Isolationsfehlersuchgerät nicht erkannt werden kann. Als Prüfstrom für ein Isolationsfehlersuchsystem kann er aktuell nicht verwendet werden.

Aus DE 10 2004 018 918 B3 sind ein Verfahren und eine Einrichtung zur Isolationsfehlersuche in ungeerdeten elektrischen Stromversorgungsnetz mit Isolationsüberwachungsgerät und Prüfstromgenerator zum Erzeugen eines in den Netzabgängen messbaren Prüfstromes bei Netzstörungen bekannt. Dabei wird bei Unterschreiten eines Isolationswiderstandes für das gesamte Stromversorgungsnetz ein Prüfstromgenerator durch das Isolationsüberwachungsgerät aktiviert, der durch netzeigene Prüfspannung einen Prüfstrom zwischen Stromversorgungsnetz und Erde innerhalb einer minimalen Prüfimpulszeit erzeugt und dieser in jeden Netzabgang über Stromwandler erfasst und ausgewertet und dadurch der fehlerhafte Netzabgang lokalisiert wird. Nachteilig sind mögliche Messfehler aufgrund von Unsymmetrien zwischen Netz- und Prüfspannung und Messfehler aufgrund fehlender Unterscheidung zwischen kapazitivem und resistivem Prüfstrom sowie Risiken durch hohe Prüfspannungen von ca. 300 V des Prüfstromgenerators, die zwar strombegrenzt sind und dadurch zumindest zusätzliche Schutzmaßnahmen erfordern.

Außerdem weisen die Stromwandler Toleranzen insbesondere der Induktivität des Widerstandes der sekundären Stromwandlerwicklung auf, die zusätzliche Ursache für Messungenauigkeiten sind. Ein weiterer Nachteil ist, dass die beiden Prozesse Isolationsüberwachung und Isolationsfehlersuche nacheinander und damit getrennt voneinander erfolgen.

Aus DE 10 2005 054 544 B4 sowie DE 20 2005 018 741 U1 sind gleichwertige Lösungen mit gleichen Nachteilen bekannt.

Einen weiteren Vorschlag zur Optimierung zur Isolationsüberwachung und Isolationsfehlersuche mit Prüfstromgenerator (PSG) enthält EP 2 664 932 B1. Dabei misst ein aktivierter Prüfstromgenerator (PSG) ständig den Isolationswiderstand des Gesamtsystems Rᵢₛₒ und kann seinen Prüfstrom I_{L} derart regeln, dass nach U_{L} = Rᵢₛₒ * I_{L} keine zu hohe Prüfspannung U_{L} entsteht. Vergrößert sich der gemessene Rᵢₛₒ, bemerkt es der Prüfstromgenerator und kann den Prüfstrom automatisch reduzieren. Den Extremfall, in dem der Isolationsfehler plötzlich ganz verschwindet, kann der Prüfstromgenerator nach dieser Methode ebenfalls bemerken und sich abschalten. Daraufhin übernimmt wieder das Isolationsüberwachungsgerät (IMD) die Messung von Rᵢₛₒ bis zum nächsten Isolationsfehler. Neben der Begrenzung der Prüfspannung bietet diese Lösung den Vorteil, dass zumindest bei auftretendem Isolationsfehler die Isolationsmessung und die Isolationsfehlersuche zu einem Prozess verschmelzen. Man hat ständig aktuelle Werte für den Isolationswiderstand Rᵢₛₒ des Stromversorgungsnetzes zur Verfügung. Das System kann Zustandsänderungen im Stromversorgungsnetz schnell erkennen, was die Ursachensuche sehr beschleunigt. In medizinischen Bereich werden dazu üblicherweise Netzstecker gezogen oder Reinigungsflüssigkeiten weggewischt, wobei sofort eine Rückmeldung kommt. Müsste man nach jedem Suchvorgang zunächst das Isolationsüberwachungsgerät (IMD) wieder aktivieren, wäre die Reaktionszeit des Gesamtsystems lang.

Nachteilig beim Stand der Technik ist, dass zur Isolationsfehlersuche ein separater Prüfstromgenerator (PSG) erforderlich ist. Die Notwendigkeit dazu ergibt sich daraus, dass die geringe Messspannung von ca. 20 V des Isolationsüberwachungsgerätes (IMD) entsprechend den geltenden Vorschriften für ungeerdeten Stromversorgungsnetze einen geringen Messstrom zur Folge hat, der sich in verzweigten Stromversorgungsnetzen verteilt und damit in den Netzabgängen noch viel geringer ist und derzeit nicht erfasst werden kann. Im medizinischen Bereich erzeugen die Prüfstromgeneratoren (PSG) einen Prüfstrom I_{L} von 1 mA. Dieser Strom ist etwa um den Faktor 20 größer als der Messstrom Iₘ eines Isolationsüberwachungsgerätes (IMD). Nachteilig bei allen bekannten Isolationsüberwachungs- und Isolationsfehlersuchsystemen für ungeerdete Stromversorgungsnetze ist außerdem, das immer nur ein System aktiv ist. Bei aktiven Isolationsüberwachungsgerät ist der Prüfstromgenerator ausgeschalten und umgekehrt.

Weiterer relevanter Stand der Technik wird in EP 3 413 062 A1 offenbart.

Der vorliegenden Erfindung liegt die Aufgabe zugrunde, ein Verfahren und eine Einrichtung zur Isolationsüberwachung und Isolationsfehlersuche in verzweigten ungeerdeten elektrischen Stromversorgungsnetzen ohne Prüfstromgenerator vorzuschlagen, wobei beide Systeme dauerhaft kontinuierlich und fehlerfrei mit geringem wirtschaftlichen Aufwand eine sichere und dauerhafte Isolationsüberwachung, Lokalisierung und Analyse von Isolationswiderständen und -fehlern pro Netzabgang ermöglichen.

Die Lösung der technischen Aufgabe beinhaltet eine Einrichtung und ein Verfahren, das den Messstrom des Isolationsüberwachungsgerätes (IMD) zur Isolationsfehlersuche dauerhaft erfasst und während der Isolationsfehlersuche die Isolationsüberwachung weiterhin aktiv ist, sodass damit Isolationsüberwachung und Isolationsfehlersuche zu einem Prozess verschmelzen und außerdem die Isolationsfehlersuche zur dauernden komplexen resistiven Isolationsüberwachung jedes Netzabganges) erweitert wird.

Diese Aufgabe wird in einem ersten Aspekt der vorliegenden Erfindung durch ein Verfahren zur Isolationsüberwachung und zur Isolationsfehlersuche für ungeerdete Stromversorgungsnetze ohne Prüfstromgenerator gemäß dem unabhängigen Anspruch 1 gelöst.

Das erfindungsgemäße Verfahren weist gegenüber dem Stand der Technik eine Reihe von Vorteilen auf. Der Hardwareaufwand für das Verfahren reduziert sich stark und die Abwärme des Prüfstromgenerators entfällt. Der Isolationsfehler wird zudem schneller lokalisiert. Sobald das Isolationsüberwachungsgerät (61) anspricht, ist auch die Lokalisierung abgeschlossen. Die Anpassung des Prüfsignals des Isolationsfehlersuchsystems an die Netzverhältnisse entfällt ebenfalls, denn hat sich das Isolationsüberwachungsgerät (61) angepasst, ist auch das Suchsystem angepasst. Mit dem Entfallen des Prüfstromgenerators entfallen auch dessen Sicherungsmaßnahmen gegen zu hohen Prüfstrom bei Bauteilfehlern. Schließlich wird die Entwicklung des Suchsystems preiswerter, weil die normativen Prüfungen des Prüfgenerators entfallen. Damit wird das System preiswerter.

Die vorstehend genannte Aufgabe wird in einem zweiten Aspekt der vorliegenden Erfindung durch eine Einrichtung zur Isolationsüberwachung und zur Isolationsfehlersuche für ungeerdete Stromversorgungsnetze ohne Prüfstromgenerator gemäß dem unabhängigen Anspruch 13 gelöst.

Als "zentrale Stelle, bzw. "elektrisch zentrale Stelle" wird gemäß der vorliegenden Erfindung der Transformator (81) des IT-Netzes angesehen. Um die Messströme an den Abgängen mit einem Stromwandler (64) messen zu können, muss ein Messstrom dort eingespeist werden. Der an der "zentralen Stelle" eingespeiste Messstrom verteilt sich von dort auf die Abgänge nach der Stromteilerregel.

Die erfindungsgemäße Einrichtung weist gegenüber dem Stand der Technik grundsätzlich die gleichen Vorteile auf wie das erfindungsgemäße Verfahren. Darüber hinaus lassen sich aus dem Gesamtmessstrom und den Teilströmen in den Abgängen die Teilwiderstände berechnen: $Riso 1 = Im / Im 1 * Riso$ $Riso 2 = Im / Im 2 * Riso$

Liegen komplexe Stromwerte anstelle der obigen Beträge vor, können Impedanzen berechnet werden: $Ziso 1 = Im / Im 1 * Ziso$ $Ziso 2 = Im / Im 2 * Ziso$

Die im Folgenden genannten weiteren Ausführungsformen können als Kombination untereinander oder einzeln realisiert werden. Wenn in der Beschreibung der erfindungsgemäßen Einrichtung Verfahrensmerkmale genannt werden, so beziehen sich diese insbesondere auf das erfindungsgemäße Verfahren. Ebenso beziehen sich gegenständliche Merkmale, die in der Beschreibung des erfindungsgemäßen Verfahrens angeführt werden, auf die erfindungsgemäße Einrichtung.

Eine vorteilhafte Weiterbildung des erfindungsgemäßen Verfahrens sieht vor, dass dieses das ferner einen oder mehreren der Teilschritte aufweist:
- Vormagnetisieren des Stromwandlerkerns,
- Vermindern hochfrequenter Störeinflüsse auf die Messelektronik,
- Einsatz rauscharmer Operationsverstärker in der Messelektronik,
- Vorsehen einer Hochpassfunktion zur Unterdrückung niederfrequenten Rauschens,
- Bandbreitenreduzierung zur Verminderung des Einflusses von Rauschen auf die Messstromerfassung (10).

Diese Weiterbildung ermöglicht es insbesondere, sehr geringe Ströme zu messen, indem das Verhältnis von Nutzsignal zu Störsignal (d.h. Rauschen) verbessert wird.

In einer erfindungsgemäßen Ausführungsform des Verfahrens laufen die Isolationsüberwachung und die Isolationsfehlersuche zeitgleich ab. Durch die Parallelität arbeitet des Suchsystem schneller. Nach dem Stand der Technik läuft erst das Isolationsüberwachungsgerät (61) und dann beginnt die Prüfung mit dem Suchsystem.

Eine Weiterbildung des erfindungsgemäßen Verfahrens sieht vor, dass die Isolationsüberwachung und die Isolationsfehlersuche bei ein- oder ausgeschaltetem Transformator (81) erfolgen. Bisher konnten die Transformatoren (81) nicht ausschalten werden, weil der Prüfstromgenerator auf die Netzspannung angewiesen war. Nun besteht die Möglichkeit, die Leerlaufleistung des Transformators (81) z.B. nachts, einzusparen.

Gemäß der Erfindung erfolgt die Messstromerfassung (10) durch mindestens eine Korrelation der Abtastwerte des Messstroms. Die Korrelation mit einem Sinussignal ist automatisch frequenzselektiv, führt also zu der benötigten Bandbreitenreduktion zwecks Rauschunterdrückung.

Gemäß einer ersten Alternative der Erfindung erfolgt die Korrelationen der Abtastwerte des Messstroms mittels einer Sinusschwingung, deren Frequenz der Messspannungsfrequenz (fₘ) der Isolationsüberwachung entspricht. Die Korrelation mit einem Sinussignal ist automatisch frequenzselektiv, führt also zu der benötigten Bandbreitenreduktion zwecks Rauschunterdrückung. Würde die Abschnitte zusammenziehen.

Gemäß einer zweiten Alternative der Erfindung erfolgt die Messstromerfassung (10) durch mindestens zwei Korrelationen der Abtastwerte des Messstromes, bevorzugt mit jeweils einer Cosinus- und einer Sinusschwingung. Insbesondere können die zwei Korrelationen der Abtastwerte des Messstroms synchronisiert sein, so dass ein komplexer Wert des Messstromes ermittelt wird, dessen Winkel auf die Messspannung bezogen ist. Liegen komplexe Stromwerte vor, können die Einzelimpedanzen der Abgänge berechnet werden, so dass der ohmsche und der kapazitive Strom einzeln erhalten werden.

Eine andere Weiterbildung des erfindungsgemäßen Verfahrens sieht vor, dass der ohmsche Isolationswiderstand (69) und der kapazitive Blindwiderstand (65) und/oder die Impedanz (67) jedes Netzabganges (79) aus dem Verhältnis von Messstrom des Isolationsüberwachungsgerätes (61) und erfassten Messstrom des Stromwandlers (64) des Netzabganges (79) multipliziert mit dem Isolationswiderstand (74) und/oder der Impedanz (67) aus Messspannung und Messstrom des Isolationsüberwachungsgerätes (61) und über Quadratmodulation ermittelt wird.

Das erfindungsgemäße Verfahren kann ferner dergestalt ausgeführt sein, dass der ohmsche Isolationswiderstand (69) und der kapazitive Blindwiderstand (65) und/oder die Impedanz (67) jedes Netzabganges (79) mithilfe der Stromteilerregel (die beschreibt, wie bei gegebenem Gesamtstrom die Teilströme einer Parallelschaltung von Widerständen berechnet werden können) aus dem Verhältnis der Einzelmessströme zum Gesamtmessstrom berechnet werden.

Das Verfahren der Isolationsüberwachung und Isolationsfehlersuche von Isolationsfehlern in den Netzabgängen (79) kann bei Überschreiten des ohmschen Isolationsfehlers dauerhaft im ein- und ausgeschalteten Zustand des Transformators (81) erfolgen.

Bei Isolationsfehlersuchsystemen ist es vorteilhaft, einen Strom möglichst niedriger Frequenz zu verwenden. Dadurch erhält man ein günstiges Verhältnis zwischen dem ohmschen Stromanteil, der über den Isolationsfehler fließt, und dem kapazitiven Anteil, der über die Netzableitkapazitäten fließt. Einer niedrigen unteren Grenzfrequenz des Isolationsfehlersuchgerätes steht aber die Strommessung mithilfe eines Stromwandlers (64) entgegen. Induktion erfordert ein möglichst hohes dl / dt, was wiederum für hohe Frequenzen spricht.

In einer weiteren erfindungsgemäßen Ausführung des Verfahrens wird im Sekundärstromkreis (2) des Stromwandlers (64) der Kupferwiderstand (91) R_{cu} der Sekundärspule (1) durch einen negativen Widerstand R_{ges} kompensiert, da R_{Cu} - R_{ges} gilt.

In einer weiteren erfindungsgemäßen Ausführung kann die differentielle Induktivität (Lₛ) der Sekundärspule (1) des Stromwandlers (64) durch Vormagnetisierung (93) des Kernes erhöht wird.

Diese beiden zuletzt genannten Ausführungen führen zu einer Verkleinerung der Grenzfrequenz des Sekundärstromkreises (2) des Stromwandlers (64).

In einer weiteren erfindungsgemäßen Ausführungsform wird vorgeschlagen, den Kern der Sekundärspule (1) des Stromwandlers (64) zu entmagnetisieren.

Damit ist ein definierter Zustand des/der Stromwandlerkerne hergestellt, die trotz ihres weichmagnetischen Verhaltens eine gewisse Remanenz besitzen. Für die Messstromerfassung (10) bietet das den Vorteil, dass ein Maximum an differentieller Induktivität Lₛ erreicht wird. Dafür kann eine Vormagnetisierungsquelle (5) verwendet werden.

In einer weiteren erfindungsgemäßen Ausführungsform wird die differentielle Induktivität Lₛ der Sekundärspule (1) des Stromwandlers (64) durch Messung der Impedanz (67) des Sekundärstromkreises (2) ermittelt. Durch die Messung der differentiellen Induktivität Lₛ kann der Einfluss von Temperatur, Alterung, Magnetisierungszustand und Exemplarstreuungen auf die Berechnung der Isolationsimpedanz beseitigt werden.

In einer weiteren erfindungsgemäßen Ausführungsform kann die Auswertung der Messströme an zentraler Stelle, bevorzugt mit einem Mikrocontroller oder durch Software, erfolgen. Dafür werden die Werte der Messströme über geeignete Kommunikationsmedien, beispielsweise Bussysteme, an die zentrale Stelle übermittelt.

Bei einer dezentralen Auswertung, beispielsweise in der komplexen Messelektronik (76), wäre es notwendig, den Messwert des Messstroms des ersten Stromwandlers (64), an die anderen Auswerteeinheiten zu übermitteln, und dann nur bei einem Fehler die Werte an die zentrale weiterzugeben.

Die Empfindlichkeit eines Isolationsfehlersuchgerätes ist durch sein Grundrauschen begrenzt. Wird das Nutzsignal zu gering, geht es im Rauschen unter. Um das Isolationsfehlersuchgerät dahingehend zu verbessern, müssen Rauschquellen beseitigt und die Sensibilität der Stromerfassung für das verbleibende Restrauschen reduziert werden. Folgende Maßnahmen, allein oder in Kombination, führen zum Ziel:
- Die verwendete Vormagnetisierungsspannung bzw. der fließende Magnetisierungsstrom überwinden die Remanenz des Eisenkernes des Stromwandlers (64). Die Weißschen Bezirke werden ständig in Bewegung gehalten und richten sich dadurch tendenziell sehr leicht nach einem fließenden Primärstrom aus. Das äußert sich als die gewünschte Erhöhung der differentiellen Induktivität der Spule. Bei der ständigen Ummagnetisierung tritt jedoch der magnetische Barkhausen-Effekt auf. Im Magnetisierungsstrom erscheint dadurch ein störender Rauschanteil. Um ihn zu verringern, kann ein sehr weichmagnetischer Kern eingesetzt und im Gegenzug der Vormagnetierungsstrom verkleinert werden.
- Koppeln hochfrequente Signale in eine Verstärkerschaltung ein, werden sie an Nichtlinearitäten z.B. den Halbleitern eines Operationsverstärkers demoduliert. Abhängig von der Amplitude der Hochfrequenz verändert sich z.B. die Offsetspannung eines Operationsverstärkers. Diesen zufälligen Störeinfluss kann man als weitere Rauschquelle betrachten.
- Im Messverstärker (3) werden rauscharme Operationsverstärker eingesetzt. Bipolare OPV mit geringer Eingangsrauschspannung eignen sich hier besonders gut.
- Die Temperaturabhängigkeit verschiedener Bauelemente des Messverstärkers (3) sorgt für eine weitere Rauschquelle. Da Temperaturänderungen an Bauelementen aber langsame Vorgänge sind, ist die spektrale Rauschdichte nur bei sehr niedrigen Frequenzen groß. Als Gegenmaßnahme genügt es daher, die untere Grenzfrequenz der Messelektronik (76) und speziell des Wandlersekundärkreises nur so niedrig wie für die Messung nötig einzustellen. Die Hochpassfunktion des Sekundärkreises filtert mit ihrer möglichst hohen Grenzfrequenz das Rauschen der tiefen Frequenzen heraus.
- Der störende Einfluss sämtlicher Rauschquellen auf die Prüfstromerfassung kann durch Bandbreitenreduktion verringert werden. Das Rauschen am Ausgang des Messverstärkers (3) ist durch eine spektrale Rauschspannungsdichte u²(f) gekennzeichnet. Möchte man den Gesamteffektivwert der Rauschspannung bestimmen, integriert man dazu u²(f) über den interessierenden Frequenzbereich des Messverstärkers (3), also von seiner untersten bis zur obersten Grenzfrequenz. Die Lösung besteht folglich darin, die Bandbreite der Signalverarbeitung nach dem Messverstärker (3) zu reduzieren. Ein selektiver Bandfilter, der genau auf den interessierenden Frequenzbereich des Stromes abgestimmt ist, unterdrückt das Restrauschen der Messelektronik (76) effektiv.

Das erfindungsgemäße Isolationsfehlersuchsystem arbeitet ohne Prüfstromgenerator und nutzt direkt den vom Isolationsüberwachungsgerät (61) (IMD) abgegebenen Messstrom von ca. 50 µA für die Isolationsfehlersuche.

In einer weiteren Ausführungsform werden der ohmsche Isolationswiderstand (69) und der kapazitive Blindwiderstand (65) und/oder die Impedanz (67) jedes Netzabganges (79) aus dem Verhältnis von Messstrom des Isolationsüberwachungsgerätes (61) und erfasstem Messstrom des Stromwandlers (64) des Netzabganges (79) multipliziert mit dem Isolationswiderstand (74) und/oder der Impedanz (67) aus Messspannung und Messstrom des Isolationsüberwachungsgerätes (61) ermittelt.

In einer weiteren alternativen Ausführungsform werden der ohmsche Isolationswiderstand (69) und der kapazitive Blindwiderstand und/oder die Impedanz (67) jedes Netzabganges (79) aus dem Verhältnis von Messstrom des Isolationsüberwachungsgerätes (61) und des erfassten Messstroms des Stromwandlers (64) des Netzabganges (79) multipliziert mit dem Isolationswiderstand (74) und/oder der Impedanz (67) aus Messspannung und Messstrom des Isolationsüberwachungsgerätes (61) und über Quadratmodulation ermittelt.

In einer weiteren Ausführungsvariante kann die Berechnung des Gesamtwidertandes des Isolationsüberwachungsgerätes (61) Rᵢₛₒ = Uₘ/Iₘ aus Messspannung und Messstrom auf die Endstromkreise ausgedehnt werden, weil die Teilströme Iₘ₁, Iₘ₂, ... nun zur Verfügung stehen. In medizinisch genutzten Bereichen mit vergleichsweise geringen Ableitkapazitäten kann die Stromteilerregel mit reellen Werten als Näherung verwendet werden, um die Isolationswiderstände pro Endstromkreis zu bestimmen. Man erhält für Berechnung der Isolationswiderstände der einzelnen Endstromkreise i = 1, 2, 3, ....: ${R}_{iso , i} = {I}_{m} / {I}_{m , i} * {R}_{iso} mit i = 1 , 2 , 3 , …$ (Gl. 1) und bei Vorliegen von komplexen Stromwerten, können Impedanzen (67) berechnet werden: ${Z}_{iso , i} = {I}_{m} / {I}_{m ,} i * {Z}_{iso} mit i = 1 , 2 , 3 …$ (Gl. 2)

Um den Isolationswiderstand (74) Rᵢₛₒ des gesamten Netzsystems berechnen zu können, ist es empfehlenswert, dass sich ein Isolationsüberwachungsgerät (61) an die Netzverhältnisse anpasst. Beim Anlegen seines Messstromes zwischen Netz und Erde (80) (PE) laden sich zunächst die Netzableitkapazitäten auf. Erst wenn dieser Ausgleichsvorgang abgeschlossen ist, stehen gültige Endwerte von Messstrom und Messspannung für die Berechnung Rᵢₛₒ = Uₘ/Iₘ zur Verfügung. Im Falle des Einsatzes eines Prüfstromgenerators muss das Isolationsfehlersuchsystem im Stand der Technik ebenfalls eine Netzanpassung vornehmen, vgl. EP 3 139 188 B1. Ohne Prüfstromgenerator ist eine separate Anpassung des Isolationsfehlersuchsystems nicht mehr erforderlich. Sobald das Isolationsüberwachungsgerät (61) sich angepasst hat, funktioniert automatisch auch das Isolationsfehlersuchsystem.

Die Messspannungsquelle von Isolationsüberwachungsgeräten IMD gibt häufig eine rechteckförmige Wechselspannung ab. Über die Ankoppelwiderstände wird die Messspannung zwischen Netz und Erde (80) (PE) angelegt. Die Frequenz der Messspannung (fₘ) wird i.d.R. so niedrig gewählt, dass ausreichend Zeit zum Aufladen der Netzableitkapazität über die Ankoppelwiderstände zur Verfügung steht. Man verwendet als Dauer der Halbschwingung gerne ein Vielfaches der Zeitkonstante des Einschwingvorganges. Die Zeitkonstante wird kontinuierlich gemessen und damit die Frequenz der Messspannung (fₘ) an die Netzverhältnisse angepasst. Dieses Verfahren ist in DE 101 06 200 C1 beschrieben.

Für das vorgeschlagene Suchsystem ist bevorzugt wesentlich, dass sich nach Netzanpassung des Isolationsüberwachungsgeräts IMD ein einfacher Wechselstrom konstanter Frequenz als Messstrom ergibt, dessen Grundschwingung schmalbandig gefiltert und dann erfasst werden kann. In einer bevorzugten Ausgestaltung werden Filterung und Erfassung in einem Schritt realisiert. Das geschieht durch Korrelation der Abtastwerte des Messstromes mit einer Sinusschwingung deren Frequenz der Messspannungsfrequenz fₘ des Isolationsüberwachungsgeräts IMD entspricht. Je mehr Messsignalperiode in die Korrelation einbezogen werden, desto geringer ist die Bandbreite der Erfassung. Realisieren lässt sich die Korrelation in Form eines FIR-Filters (digitale Signalverarbeitung) der Normalform 1, wobei an die Stelle der Filterkoeffizienten einfach die Funktionswerte der Sinusschwingung treten. Mit jedem neuen Abtastwert steht auch ein neues Korrelationsergebnis zur Verfügung. Nachteilig ist, dass die Abtastwerte des Messstromes an der feststehenden Sinusschwingung vorbeigleiten. Bei Phasengleichheit zwischen der Grundschwingung des Messstromes und dem Sinus ist das Korrelationsergebnis maximal. Bei 90° Phasenverschiebung wird es Null. Man erhält periodisch schwankende Werte für den Messstrom. Abhilfe schafft eine zweite, gleichartige Korrelation mit einer Cosinusfunktion. Beide Korrelationsergebnisse können dann über den Satz des Pythagoras zu einem Betrag zusammengerechnet werden, der unabhängig von der Phasenlage immer konstant ist.

In einer weiteren Ausgestaltung stehen Sinus- und Cosinusfunktion für die beiden Korrelationen nicht fest, sondern werden mit der Messspannung des Isolationsüberwachungsgeräts IMD synchronisiert. An den Korrelatoren liegen demnach der Messstrom und die beiden Winkelfunktionen phasenstarr zueinander an. Das Verhalten ähnelt dem eines Quadraturdemodulators (33). Die Grundschwingung des Messstromes wird in einen Cosinus- und einen Sinusanteil zerlegt. Nach dieser Methode hat man den Messstrom als komplexen Wert zur Verfügung und kann die oben genannte Impedanzberechnung durchführen. Im Ergebnis sind nicht nur die ohmschen Isolationswiderstände (694) in den Endstromkreisen bekannt, sondern auch die zugehörigen Ableitkapazitäten. Berücksichtigen muss man bei dieser Ausgestaltung die Phasenverschiebung zwischen den Grundschwingungen von Messspannung und Messstrom des Isolationsüberwachungsgeräts IMD. Hier wirken Netzableitkapazität, Ankoppelwiderstand und Isolationswiderstand (74) des gesamten Netzes. Auch zu berücksichtigen ist die Phasenverschiebung der Messelektronik (76) des Suchgerätes.

Am Stromwandler (64) eines Suchgerätes wirkt der Messstrom als Primärstrom. Der im Sekundärkreis induzierte Strom zeigt bezüglich des Primärstromes ein Hochpassverhalten. Die Hochpassfunktion wird bestimmt durch den ohmschen Gesamtwiderstand R_{ges} und die differentielle Induktivität der Sekundärspule (1) Lₛ. Die differentielle Induktivität der Sekundärspule (1) Lₛ unterliegt starken Exemplarstreuungen und ist außerdem abhängig vom Magnetisierungszustand des Wandlerkernes. Damit streut auch das Verhalten des Hochpasses stark, was seinen Amplitudengang aber ganz besonders seinen Phasengang unberechenbar macht. Somit reduziert sich die Genauigkeit der vorgeschlagenen Impedanzberechnung. In einer weiteren Ausgestaltung wird daher Lₛ im laufenden Betrieb des Suchgerätes ermittelt. Nach DE 10 2005 054 544 B4 enthält der Sekundärstromkreis (2) bereits eine Spannungseinkopplung, über die zusätzlich zu anderen Signalen eine Analysespannung Uₐ in den Stromkreis eingekoppelt werden kann. Die Impedanz (67) Zₛ der Reihenschaltung aus R_{ges} und Lₛ bestimmt den sich ausbildenden Analysestrom Iₐ und kann mit Zₛ = Uₐ/Iₐ berechnet werden. Aus dem Imaginärteil von Zₛ erhält man dann Lₛ. Es ist vorteilhaft, für die Frequenz fₐ der Analysespannung ein ganzzahliges Vielfaches der Frequenz der Messspannung fm zu wählen. Dadurch liefern die Korrelatoren der Messstromerfassung (10) für den Analysestrom das Ergebnis Null. Der Analysestrom stört somit die Messstromerfassung (10) des Suchgerätes nicht.

Wesentliche Vorteile des erfindungsgemäßen Verfahrens und der erfindungsgemäßen Einrichtung gegenüber dem Stand der Technik sind:
- Wegfall des Prüfstromgenerators (62): Während nach dem Stand der Technik zunächst das Isolationsüberwachungsgerät (61) gestoppt werden muss und dann der Prüfstromgenerator (62) erst gestartet werden kann, ist nun die Fehlerortung bereits abgeschlossen, wenn das Isolationsüberwachungsgerät (61) den Isolationsfehler meldet.
- schnelles und direktes Messverfahren mit wesentlich geringerer Messspannung von beispielsweise ca. 20 V und sehr geringen und damit ungefährlichen Messströmen kleiner als 1 mA, bevorzugt kleiner als 500 µA, besonders bevorzugt kleiner als 100 µA, insbesondere bevorzugt von ca.50 µA gegenüber ca. 300 V und ca. 1 mA bei Einsatz des Prüfstromgenerator (62) zur Isolationsfehlersuche, so dass die mittels der Stromwandler (64) anteiligen gemessenen Messströme kleiner als 0,2 mA ist, besonders bevorzugt kleiner als 0,05 mA und ca. 7 µA sein können,
- Funktionalität ist auch bei stromlosem Netzleiter, also bei ein- und abgeschalteten Stromversorgungsnetz, gewährleistet,
- ganzheitliche und permanente Informationen der Qualität des Stromversorgungsnetzes und deren Verbraucher,
- keine Probleme der Wärmeabfuhr, die bei der Erzeugung eines Prüfstromes mit linearen Stromreglern entstehen.

Der Prüfstromgenerator (62) ist zwar nach dem Stand der Technik i. d. R. kein separates Gerät für den Schaltschrankeinbau mehr, aber er existiert als Schaltungsteil beispielsweise in Isolationssuchgeräten oder in kombinierten Geräten zur Isolationsüberwachung und Isolationsfehlersuche. Dort verursacht er einen zusätzlichen Bauteilaufwand. Noch schwerwiegender ist aber sein Platzbedarf auf den Platinen. Wegen der Kopplung der Generatorschaltung ans Netz muss zu berührbaren Teilen der Geräteelektronik und zur Erde (80) (PE) eine ausfallsichere Isolierung mit entsprechenden Luft- und Kriechstrecken vorgesehen werden. Prüfstromgeneratoren dürfen auch bei Bauteilfehlern keinen zu hohen Prüfstrom erzeugen. Diese Forderung wird durch die hohen und ausfallsicheren Ankoppelwiderstände der Isolationsüberwachung ohne zusätzliche Maßnahmen erfüllt. Allgemein reduziert sich der normative Prüfaufwand für ein Isolationsfehlersuchsystem stark, wenn der Prüfstromgenerator entfällt. Die Konformität der Isolationsüberwachung genügt bereits. Das führt letztendlich zu einer Preisersparnis beim Einsatz erfindungsgemäßer Suchsysteme.

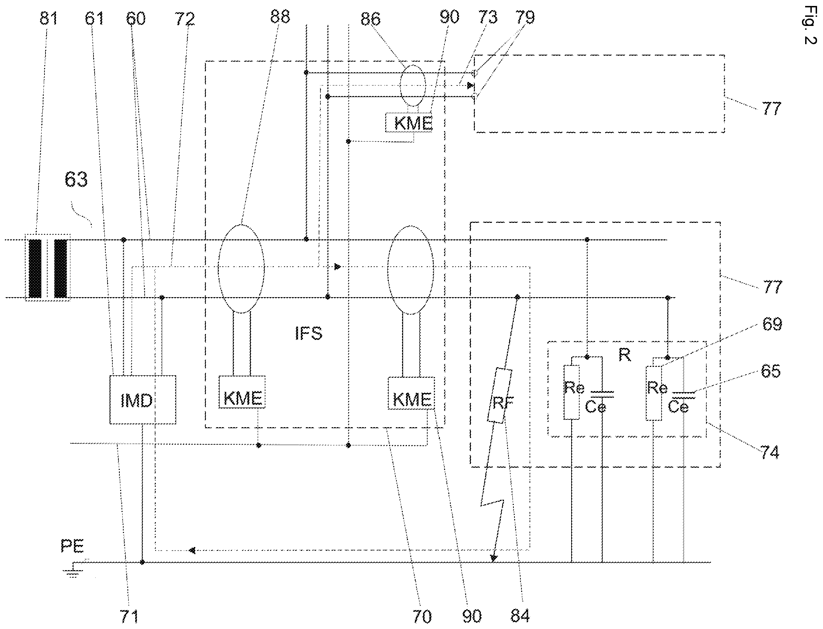

Weitere Ziele, Merkmale, Vorteile und Anwendungsmöglichkeiten ergeben sich aus der nachfolgenden Beschreibung von die Erfindung nicht einschränkenden Ausführungsbeispielen anhand der Figuren. 2. Der Gegenstand der Erfindung wird durch die angefügten Ansprüche definiert. Es zeigen:
- Fig. 1: eine Einrichtung und Verfahren zur Isolationsüberwachung und Isolationsfehlersuche entsprechend dem Stand der Technik,
- Fig. 2: eine Einrichtung und Verfahren zur Isolationsüberwachung und Isolationsfehlersuche entsprechend einer bevorzugten Ausführungsform der vorliegenden Erfindung,
- Fig. 3: ein erstes Blockschaltbild des Signalflussplans des erfindungsgemäßen Verfahrens in einer bevorzugten Ausführungsform,
- Fig. 4: ein zweites Blockschaltbild des Signalflussplans des erfindungsgemäßen Verfahrens in einer bevorzugten Ausführungsform und
- Fig. 5: ein drittes Blockschaltbild des Signalflussplans zur korrelativen Erfassung des Messstromes über Quadratmodulation.

In den Figuren werden alle gleichen Bauteile mit den gleichen Bezugszeichen benannt, aus Gründen der Übersichtlichkeit sind aber nicht in allen Darstellungen alle Bezugszeichen eingefügt.

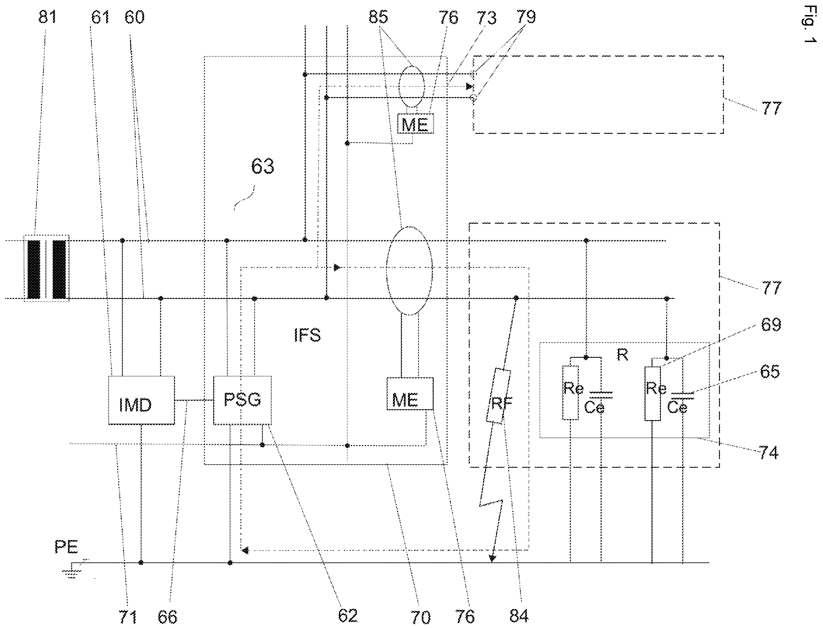

Fig. 1 zeigt den Stand der Technik der Isolationsüberwachung und der Isolationsfehlersuche in ungeerdeten Stromversorgungsnetzen. Ein Isolationsüberwachungsgerät IMD erzeugt über eine Konstantspannungsquelle eine geringe Messspannung, die einen geringen Messstrom in das ungeerdete Stromversorgungsnetz 63 zwischen den Netzleitern 60 und Erde 80 PE einspeist, und ermitteln und überwacht daraus den gesamten Isolationswiderstand 74 Rᵢₛₒ des Stromversorgungsnetzes. Wird ein Ansprechwert Rₐₙ unterschritten, erzeugt das Isolationsüberwachungsgerät IMD 61 eine Fehlermeldung und das Isolationsfehlersuchsystem IFS, bestehend aus Prüfstromgenerator PSG 62, Stromsensoren 85 und Messelektronik ME 76, wird gestartet, indem über eine Verbindung 66 der Prüfstromgenerator PSG 62 aktiviert wird. Der Prüfstromgenerator 62 erzeugt aus der Netzspannung eine höhere Prüfspannung als die Messspannung des Isolationsüberwachungsgerätes 61 und einen gegenüber dem Messstrom des Isolationsüberwachungsgerätes 61 höheren Prüfstrom zwischen Netzleiter 60 und Erde 80 PE. Der anteilige Prüfstrom 73 wird in den Endstromkreisen 77 über Prüfstromsensoren 85 erfasst und daraus über die Messelektronik 76 ME der jeweilige Isolationswiderstand 74 des Endstromkreises 77 ermittelt. Dieser Isolationswiderstand 74 des Endstromkreises 77 wird über Busleitungen 71 zur zentralen Meldung übertragen und dadurch der fehlerhafte Endausgang ermittelt und lokalisiert. Nach Abstellen des Isolationsfehlers vor Ort wird das Isolationsüberwachungsgerät IMD 61 wieder aktiv und über die Verbindung 66 wird der Prüfstromgenerator PSG 62 deaktiviert.

Fig. 2 zeigt die Isolationsüberwachung und Isolationsfehlersuche ohne Prüfstromgenerator 62 PSG für ein ungeerdetes Stromversorgungsnetz 63 entsprechend der vorliegenden Erfindung mit Isolationsüberwachungsgerät IMD 61, das dauernd über die Messspannung einen geringen Messstrom in das ungeerdete Stromversorgungsnetz 63 zwischen Netzleiter 60 und Erde 80 PE einspeist. In dem Stromnetz wird unmittelbar nach dem Isolationsüberwachungsgerät IMD 61 der Messstrom 88 und an jedem Endgerät 77 der anteilige Messstrom über Stromsensoren 86 erfasst und die komplexe Messstromelektronik KME 90 ermittelt daraus den zugehörigen ohmschen Isolationswiderstand 69 und den kapazitiven Blindwiderstand 65. Das Isolationsfehlersuchsystem ist dauerhaft, auch bei ausgeschaltetem Transformator 81, in Betrieb und dadurch werden alle ohmschen Isolationswiderstände 69 und kapazitiven Blindwiderstände 65 ermittelt, lokalisiert, über geeignete Kommunikationsmedien (Bussysteme) an eine Zentrale gemeldet und bewertet.

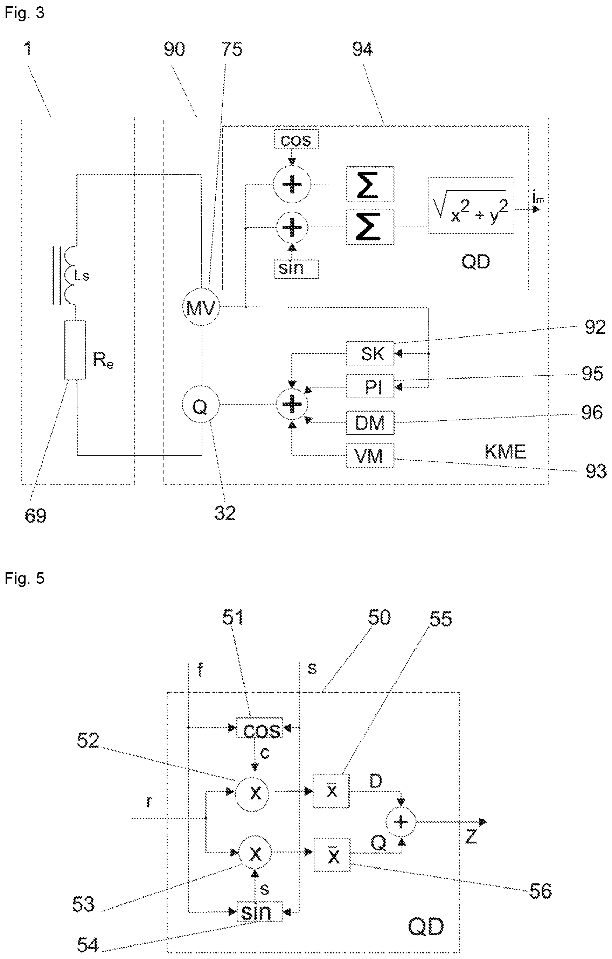

Fig. 3 zeigt den Signalflussplan zum erfindungsgemäßen Verfahren zur Isolationsfehlersuche über den sekundären Stromkreis des Stromwandlers 64, der mittels des Ersatzschaltbildes aus Kupferwiderstand 91(R_{Cu} der Wicklung und induktivem Widerstand L_{S} dargestellt ist. Der Stromwandler 64 erfasst den Messstrom, der in der komplexen Messstromelektronik 90 KME durch Verstärken desselben über Messverstärker 3 und Kompensation von Messfehlern und Störungen den ohmschen Isolationswiderstand 69 und kapazitiven Blindwiderstand 65 des Teilnetzes ermittelt.

In der komplexen Messelektronik kann über eine steuerbare Spannungsquelle:
- der Kupferwiderstand 91 R_{Cu} der sekundären Stromwandlerwicklung des Stromwandlers 64 mittels variablem negativem Widerstand über eine Sekundärsteuerung 92 SK kompensiert werden, oder/und über eine Vormagnetisierung 93 Q die Remanenz des Kerns des Stromwandlers 64 beseitigt werden, und /oder der Kern des Differenzstromwandlers entmagnetisiert werden, und/oder
- Funkstörungen über äquivalenten Primärrauschstrom kompensiert werden,
- der Messstrom in einem variablen Arbeitspunkt des Stromwandlers 64 über Einspeisung einer variablen Spannung über Vormagnetisierung 93 VM mit minimalem Barkhausen-Rauschen erfasst werden, das über Quadratmodulator 94 QD mit anschließender resistiver Betragsbildung eine weitere Reduktion des Rauschpegels durch Bandbreitenreduktion erfolgt,
- eine Unterscheidung von ohmschem und kapazitivem Messstrom über Erfassung und Auswertung einer Harmonischen des Messstromes mit Phasenwinkel bezogen auf die Messspannung des Isolationsüberwachungsgerätes 61 über Quadratmodulation QM erfolgen, oder mehrere Harmonische von Messspannung und ausgewertet werden,
- über die Einspeisung einer variablen Demagnetisierungsspannung DM die Messung der Impedanz 67 der Sekundärwicklung des Stromwandlers 64 erfolgen,
- der Nullpunktabgleich des Sekundärstromkreises des Stromwandlers 64 über Pl-Regler 95 mit zeitabhängigen Parametern erfolgen.

Dadurch ist es möglich, Messströme von ca. 7 µA im Frequenzbereich von 0,1 bis 7,0 Hz zu erfassen.

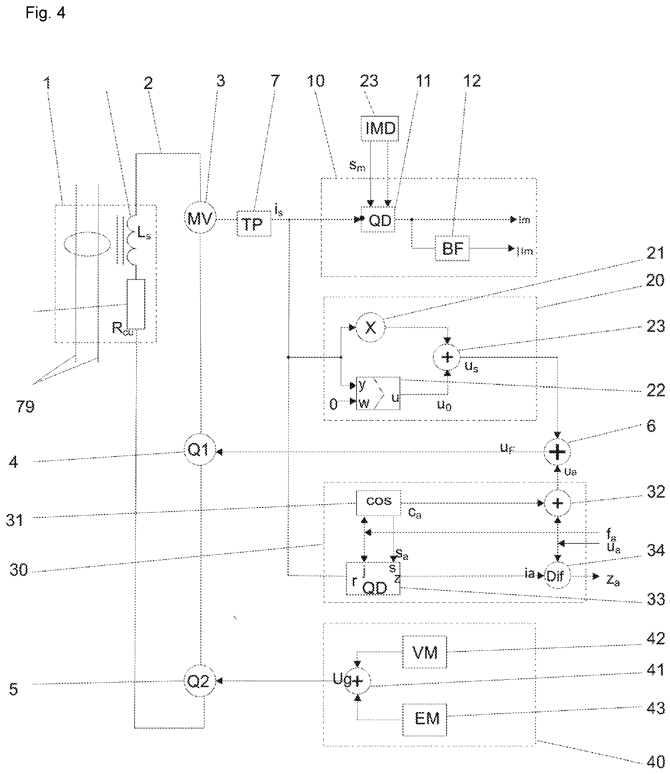

Fig. 4 zeigt die Signalverarbeitung zu dem erfindungsgemäßen Verfahren. Handelt es sich um Zeitfunktionen, sind Signale mit Kleinbuchstaben benannt. Hinter Großbuchstaben stecken Zeiger bzw. komplexe Größen. Der Messverstärker 3 wandelt den fließenden Messstrom in den Netzleitern 60 in das Sekundärstromsignal iₛ um. Die steuerbaren Spannungsquellen 4, 5 wandeln Spannungssignale in Spannungen um, die in den Sekundärstromkreis 2 einkoppeln. Die Signalverarbeitung läuft i.d.R. digital ab. Der Tiefpass 7 sichert die Einhaltung des Abtasttheorems. Er ist hier mit dargestellt, weil er eine Phasenverschiebung des Sekundärstromes iₛ bewirkt, die z.B. bei Impedanzberechnungen beachtet werden muss.

Der Quadraturdemodulator QD 11 der Messstromerfassung 10 läuft mit derselben Frequenz, mit der das Isolationsüberwachungsgerät IMD 61 seine Messspannung erzeugt. Das primäre Ergebnis der Messstromerfassung 10 ist der Betrag des Messstromes |Iₘ|.

In einer weiteren Ausgestaltung sind Quadraturdemodulator QD 11 und Isolationsüberwachungsgerät IMD 61 über das Synchronisations-Signal sₘ synchronisiert. In diesem Fall ist der komplexe Messstrom (Iₘ) für eine Impedanzberechnung nutzbar.

Die Sekundärkreissteuerung 20 kompensiert den Kupferwiderstand 91 R_{cu} der Sekundärspule 1 und regelt den Sekundärstrom iₛ auf 0; sie gibt die Spannung der Sekundarkreissteuerung 20 uₛ aus. Die Widerstandkompensation realisiert der Multiplizierer 52, 53 mit dem Faktor -R_{cu}. Der PI-Regler 95 erhält den Sekundärstrom iₛ als Führungsgröße und den Wert 0 als Sollwert. Die Offsetspannung uₒ ist die Stellgröße. Über die Parameter des PI-Reglers 95 kann die untere Grenzfrequenz des Sekundärkreises eingestellt werden. Eine möglichst hohe Grenzfrequenz reduziert das Rauschen der tiefen Frequenzen, das durch Temperaturänderungen im Sekundärkreis 2 entstehen kann.

Eine weitere Ausgestaltung ist die Sekundärkreisanalyse 30. Sie speist eine Analysespannung uₐ in Cosinusform mit der Amplitude Ua in den Sekundärkreis 2 ein. Der QD 33 filtert aus dem Sekundärstrom iₛ den Anteil mit der Analysefrequenz fₐ heraus und liefert den komplexen Analysestrom Iₐ. Der Dividierer 34 berechnet die Impedanz 67 Zₐ = Uₐ / Iₐ. Über das Synchronisations-Signal sₐ synchronisiert der 1. Cosinus-Generator 31 den QD 33. Zₐ ist nach der Fig. 4 die resultierende Impedanz 67 des Sekundärkreises 2, also unter dem Einfluss der Sekundärkreissteuerung 20. Um an die reinen Spulendaten zu kommen, kann man die Sekundärkreissteuerung 20 während der Analyse abschalten oder ihren Einfluss herausrechnen. Der Einfluss ist eine bekannte Größe.

Die Magnetisierungssteuerung 40 enthält den Entmagnetisiergenerator 43, der den Wandlerkern beim Start entmagnetisiert. Der Vormagnetisiergenerator 42 erweicht mit seinem Signal den Wandlerkern während der Messung bzw. Messstromerfassung 10. Die Ausgangsgröße ist die Magnetisierungsspannung u_{g}.

Fig. 5 verdeutlicht die Verarbeitung des Quadraturdemodulator QD. Der 2. Cosinus-Generator 51 erhält als Eingangssignal die zu erzeugende Frequenz f. Beim Eintreffen eines Synchronisationssignals s springt der 2. Cosinus-Generator 51 auf die Phasenwinkel 0 Grad zurück. Der Signalausgang c des 2. Cosinus-Generators 51 mit dem Wertebereich -1 bis 1. Der Sinus-Generator 54 arbeitet genauso. Die Mittelwertberechnung 55, 56 bilden den gleitenden Mittelwert über eine gewisse Zeit, die einem Vielfachen N der Periodendauer der Signalgeneratoren entspricht. Das Vielfache N wird zweckmäßig gewählt, z.B. N = 3. Ein hohes N reduziert die Bandbreite des QD, verlängert aber die Einschwingzeit der Mittelwertbildung. Niedrige Bandbreite heißt geringe Empfindlichkeit für Restrauschen. Liegt also am Eingang r des QD ein Cosinus-Signal synchron zum 2. Cosinus-Generator 51 an, nimmt D den Wert 1 an und Q nimmt den Wert 0 an. Der Summierer 57 bildet die komplexe Zahl Z = D + jQ.

### Liste der Bezugszeichen

- 1: Ersatzschaltung Sekundärspule
- 2: Sekundärstromkreis
- 3: Messverstärker MV
- 4: Rückkopplungsquelle
- 5: Magnetisierungsquelle
- 6: Summierer, Rückkoppelspannung u_{f}
- 7: Tiefpass-Bandbreite
- 10: Messstromerfassung
- 11: Quadraturdemodulator Messstrom
- 12: Betragsfunktion |Im|
- 20: Sekundärkreissteuerung
- 21: Widerstandskompensation
- 22: Sekundärstromregler
- 30: Sekundärkreisanalyse
- 31: 1. Cosinus-Generator
- 32: Summierer
- 33: Quadraturdemodulator-Analysestrom
- 34: Dividierer - Impedanzberechnung
- 40: Magnetisierungssteuerung
- 42: Vormagnetisiergenerator
- 43: Entmagnetisiergenerator
- 50: Quadraturdemodulator QD
- 51: 2. Cosinus-Generator
- 52: Multiplizierer
- 53: Multiplizierer
- 54: Sinus-Generator
- 55: Gleitende Mittelwertberechnung
- 56: Gleitende Mittelwertberechnung
- 57: Summierer, der Z = D + jQ liefert.
- 60: Netzleiter
- 61: Isolationsüberwachungsgerät IMD
- 62: Prüfstromgenerator PSG
- 63: Stromversorgungsnetz
- 64: Stromwandler
- 65: kapazitiver Blindwiderstand Cₑ
- 66: Verbindung
- 67: Impedanz Z
- 68: Netzstörung
- 69: Ohmscher Isolationswiderstand Rₑ
- 70: Isolationsfehlersucheinrichtung IFS
- 71: Busleitung
- 72: Messstrom Iₘ
- 73: Prüfstrom IP
- 74: Isolationswiderstand
- 76: Messelektronik ME
- 77: Endgerät
- 79: Netzabgang
- 80: Erde PE
- 81: Transformator
- 82: Messspannung
- 83: Prüfspannung
- 84: Isolationsfehler R_{F}
- 85: Prüfstromsensor
- 86: Messstromsensor Endgerät
- 87: Isolationswiderstand-Ansprechwert Rₐₙ
- 88: zentraler Messstromsensor
- 89: Plausibilitätsprüfung
- 90: komplexe Messstromelektronik KME
- 91: Kupferwiderstand R_{Cu}
- 92: Sekundärsteuerung SK
- 93: Vormagnetisierung VM
- 94: Quadratmodulator QD
- 95: Pl-Regler PI
- 96: variable Demagnetisierungsspannung DEMAG

## Patentansprüche

1. Verfahren zur Isolationsüberwachung und zur Isolationsfehlersuche für ungeerdete Stromversorgungsnetze ohne Prüfstromgenerator, umfassend
A) Bereitstellen einer dauerhaften Messspannung zwischen Netzleiter (60) und Erde (80) und Einspeisung eines Messstroms mittels Isolationsüberwachungsgerät (61),
B) Bestimmung der Messströme mittels mindestens einem Stromwandler (64) angeordnet an jedem Netzabgang (79),
C) Bestimmung des Gesamt-Messstroms und der anteiligen Messströme in den Netzabgängen (79) mittels Isolationsüberwachungsgerät (61),
D) Auswertung der erfassten Messströme, wobei
E) der Messstrom der Isolationsüberwachung des Gesamtnetzes auch für die Isolationsfehlersuche in den einzelnen Stromkreisen des Netzes verwendet wird, und
**dadurch gekennzeichnet, dass** das Verfahren weiterhin umfasst
F) aus dem zeitlichen Verlauf des Messstromes jedes Stromwandlers (64) und der Messspannung des Isolationsüberwachungsgerätes (61) die Ermittlung und Auswertung des ohmschen Isolationswiderstandes (69) und des kapazitiven Blindwiderstandes (65) jedes Netzabganges (79) erfolgt,
wobei die Messstromerfassung (10) durch mindestens eine Korrelation der Abtastwerte des Messstroms erfolgt, wobei
die Korrelationen der Abtastwerte des Messstroms mittels einer Sinusschwingung, deren Frequenz der Messspannungsfrequenz fₘ des Isolationsüberwachung entspricht, erfolgt,
oder
die Messstromerfassung (10) durch mindestens zwei Korrelationen der Abtastwerte des Messstromes, bevorzugt mit einer Cosinus- und einer Sinusschwingung erfolgt, wobei die zwei Korrelationen der Abtastwerte des Messstroms synchronisiert sein können, und ein komplexer Wert des Messstromes ermittelt wird, dessen Winkel auf die Messspannung bezogen ist.

2. Verfahren nach Anspruch 2, das ferner die einen oder mehreren der Teilschritte aufweist:
- Vormagnetisieren des Stromwandlerkerns,
- Vermindern hochfrequenter Störeinflüsse auf die Messelektronik,
- Einsatz rauscharmer Operationsverstärker in der Messelektronik,
- Vorsehen einer Hochpassfunktion zur Unterdrückung niederfrequenten Rauschens,
- Bandbreitenreduzierung zur Verminderung des Einflusses von Rauschen auf die Messstromerfassung (10).

3. Verfahren nach Anspruch 1 oder 2, wobei die Isolationsüberwachung und die Isolationsfehlersuche zeitgleich ablaufen.

4. Verfahren nach einem der Ansprüche 1 bis 3, wobei die Isolationsüberwachung und die Isolationsfehlersuche bei eingeschaltetem oder bei ausgeschaltetem Transformator (81) erfolgen.

5. Verfahren nach einem der Ansprüche 1 bis 4, wobei im Sekundärstromkreis (2) der Stromwandler (64) der Kupferwiderstand (R_{cu}) (91) der Sekundärspule (1) durch einen negativen Widerstand kompensiert wird.

6. Verfahren nach Anspruch 1, wobei der ohmsche Isolationswiderstand (69) und der kapazitive Blindwiderstand (65) und/oder die Impedanz (67) jedes Netzabganges (79) mithilfe der Stromteilerregel aus dem Verhältnis der Einzelmessströme zum Gesamtmessstrom berechnet werden.

7. Verfahren nach einem der Ansprüche 1 bis 6, wobei die Isolationsüberwachung und Isolationsfehlersuche von Isolationsfehlern in den Netzabgängen (79) dauerhaft im ein- und ausgeschalteten Zustand des Transformators (81) erfolgen.

8. Verfahren nach einem der Ansprüche 1 bis 7, wobei die differentielle Induktivität (Lₛ) der Sekundärspule (1) des Stromwandlers (64) durch eine Vormagnetisierung erhöht wird.

9. Verfahren nach einem der Ansprüche 1 bis 8, wobei der Stromwandlerkern der Sekundärspule (1) des Stromwandlers (64) entmagnetisiert wird.

10. Verfahren nach einem der Ansprüche 1 bis 9, wobei die differentielle Induktivität (Lₛ) der Sekundärspule (1) des Stromwandlers (64) durch Messung der Impedanz (65) des Sekundärstromkreises (2) ermittelt wird.

11. Verfahren nach einem der Ansprüche 5 bis 10, wobei ein Nullpunktabgleich des Sekundärstromkreises (2) des Differenzstromwandlers und die Kompensation des Kupferwiderstand (R_{cu}) (91) der Sekundärspule (1) durch den selben Proportional-Integral-Regler (95) erfolgt.

12. Verfahren nach einem der Ansprüche 1 bis 11, wobei die Auswertung der Messströme an zentraler Stelle erfolgt und die Werte der Messströme über geeignete Kommunikationsmedien an die zentrale Stelle übermittelt werden.

13. Einrichtung zur Isolationsüberwachung und zur Isolationsfehlersuche für ungeerdete Stromversorgungsnetze ohne Prüfstromgenerator, umfassend
- ein Isolationsüberwachungsgerät (61) anordenbar an zentraler Stelle des Versorgungsnetzes,
wobei das Isolationsüberwachungsgerät (61) dazu ausgelegt ist, eine dauerhafte Messspannung zwischen Netzleiter (60) und Erde (80) zu erzeugen und einen Messstrom einzuspeisen,
- mindestens einen Stromwandler (64) anordenbar in jedem Netzabgang (79) zentral an der Einspeisung des Stromversorgungsnetzes (63) zwischen Isolationsüberwachungsgerät (61) und erstem Netzabgang (79), der zur zeitlichen Erfassung des Verlaufs des eingespeisten Messstroms des Isolationsüberwachungsgeräts (61) und der anteiligen Messströme des Isolationsüberwachungsgerätes (61) an den Netzabgängen (79) bei ein- oder ausgeschaltetem Transformator (81) ausgelegt ist,
- mindestens ein Auswertegerät zur Auswertung der erfassten Messströme, **dadurch gekennzeichnet, dass** das Auswertegerät ausgebildet ist,
den Messstrom der Isolationsüberwachung des Gesamtnetzes auch für die Isolationsfehlersuche in den einzelnen Stromkreisen des Netzes zu verwenden, und aus dem zeitlichen Verlauf des Messstromes jedes Stromwandlers (64) und der Messspannung des Isolationsüberwachungsgerätes (61) die Ermittlung und Auswertung des ohmschen Isolationswiderstandes (69) und des kapazitiven Blindwiderstandes (65) jedes Netzabaanaes (79) auszuführen,
wobei die Messstromerfassung (10) durch mindestens eine Korrelation der Abtastwerte des Messstroms erfolgt,
wobei die Korrelationen der Abtastwerte des Messstroms mittels einer Sinusschwingung, deren Frequenz der Messspannungsfrequenz fₘ der Isolationsüberwachung entspricht, erfolgt,
oder
die Messstromerfassung (10) durch mindestens zwei Korrelationen der Abtastwerte des Messstromes, bevorzugt mit einer Cosinus- und einer Sinusschwingung erfolgt, wobei die zwei Korrelationen der Abtastwerte des Messstroms synchronisiert sein können, und ein komplexer Wert des Messstromes ermittelt wird, dessen Winkel auf die Messspannung bezogen ist.

## Claims

1. A method for insulation monitoring and insulation fault location for unearthed power supply networks without a testing current generator, comprising
A) providing a permanent measuring voltage between the mains conductor (60) and earth (80) and feeding in a measuring current by means of an insulation monitoring device (61),
B) determining the measuring currents by means of at least one current transformer (64) arranged at each mains outgoing circuit (79),
C) determining the total measuring current and the proportional measuring currents in the mains outgoing circuits (79) by means of an insulation monitoring device (61),
D) evaluating the measuring currents detected, wherein
E) the measuring current of the insulation monitoring of the entire network is also used for insulation fault location in the individual circuits of the network, and
**characterised in that** the method further comprises
F) the ohmic insulation resistance (69) and the capacitive reactance (65) of each mains outgoing circuit (79) are determined and analysed from the variation over time of the measuring current of each current transformer (64) and the measuring voltage of the insulation monitoring device (61),
wherein the measuring current detection (10) is performed by at least one correlation of the sampled values of the measuring current, wherein
the correlations of the sampled values of the measuring current are carried out by means of a sinusoidal oscillation whose frequency corresponds to the measuring voltage frequency fₘ of the insulation monitoring,
or
the measuring current detection (10) is carried out by at least two correlations of the sampled values of the measuring current, preferably with a cosine and a sine oscillation, wherein the two correlations of the sampled values of the measuring current can be synchronised, and a complex value of the measuring current is determined, the angle of which is related to the measuring voltage.

2. The method according to claim 1, further comprising one or more of the substeps
- pre-magnetising the current transformer core,
- reducing high-frequency interference on the measurement electronics,
- using low-noise operational amplifiers in the measurement electronics,
- providing a high-pass function to suppress low-frequency noise,
- bandwidth reduction to reduce the influence of noise on the measuring current detection (10).

3. The method according to claim 1 or 2, wherein the insulation monitoring and the insulation fault location run simultaneously.

4. The method according to any of claims 1 to 3, wherein the insulation monitoring and the insulation fault location take place when the transformer (81) is switched on or switched off.

5. The method according to any of claims 1 to 4, wherein in the secondary circuit (2) of the current transformer (64) the copper resistance (R_{cu}) (91) of the secondary coil (1) is compensated by a negative resistance.

6. The method according to claim 1, wherein the ohmic insulation resistance (69) and the capacitive reactance (65) and/or the impedance (67) of each mains outgoing circuit (79) are calculated from the ratio of the individual measuring currents to the total measuring current using the current divider rule.

7. The method according to any of claims 1 to 6, wherein the insulation monitoring and insulation fault detection of insulation faults in the mains outgoing circuit (79) are carried out permanently in the switched-on and switched-off state of the transformer (81).

8. The method according to any of claims 1 to 7, wherein the differential inductance (Lₛ) of the secondary coil (1) of the current transformer (64) is increased by a premagnetisation.

9. The method according to any of claims 1 to 8, wherein the current transformer core of the secondary coil (1) of the current transformer (64) is demagnetised.

10. The method according to any of claims 1 to 9, wherein the differential inductance (Lₛ) of the secondary coil (1) of the current transformer (64) is determined by measuring the impedance (65) of the secondary circuit (2).

11. The method according to any of claims 5 to 10, wherein a zero-point adjustment of the secondary circuit (2) of the differential current transformer and the compensation of the copper resistance (R_{cu}) (91) of the secondary coil (1) is performed by the same proportional-integral controller (95).

12. The method according to any of claims 1 to 11, wherein the evaluation of the measuring currents is carried out at a central point and the values of the measuring currents are transmitted to the central point via suitable communication media.

13. A device for insulation monitoring and insulation fault location for unearthed power supply networks without testing current arrangeable, comprising
- an insulation monitoring device (61) orderable at a central point of the supply network,
wherein the insulation monitoring device (61) is designed to generate a permanent measuring voltage between the mains conductor (60) and earth (80) and to feed in a measuring current,
- at least one current transformer (64) arrangeable in each mains outgoing circuit (79) centrally at the infeed of the power supply network (63) between the insulation monitoring device (61) and the first mains outgoing circuit (79), which is designed for the temporal recording of the course of the fed-in measuring current of the insulation monitoring device (61) and the proportional measuring currents of the insulation monitoring device (61) at the mains outgoing circuits (79) when the transformer (81) is switched on or off,
- at least one evaluation device for evaluating the measuring currents detected,
**characterized in that** the evaluating device is designed
to use the measuring current of the insulation monitoring of the overall network also for insulation fault location in the individual circuits of the network, and
to carry out the measuring current of each current transformer (64) and the measuring voltage of the insulation monitoring device (61) to determine and analyse the ohmic insulation resistance (69) and the capacitive reactance (65) of each mains outgoing circuit (79) over time,
wherein the measuring current detection (10) is performed by at least one correlation of the sampled values of the measuring current, wherein
the correlations of the sampled values of the measuring current are carried out by means of a sinusoidal oscillation whose frequency corresponds to the measuring voltage frequency fₘ of the insulation monitoring,
or
the measuring current detection (10) is carried out by at least two correlations of the sampled values of the measuring current, preferably with a cosine and a sine oscillation, wherein the two correlations of the sampled values of the measuring current can be synchronised, and a complex value of the measuring current is determined, the angle of which is related to the measuring voltage.

## Revendications

1. Procédé de surveillance de l'isolement et de recherche de défauts d'isolement pour des réseaux d'alimentation électrique non mis à la terre sans générateur de courant d'essai, comprenant
A) la fourniture d'une tension de mesure permanente entre un conducteur du réseau (60) et la terre (80), et l'injection d'un courant de mesure au moyen d'un appareil de surveillance de l'isolement (61),
B) la détermination des courants de mesure au moyen d'au moins un transformateur de courant (64) disposé au niveau de chaque départ de réseau (79),
C) la détermination du courant de mesure total et des courants de mesure partiels dans les départs de réseau (79) au moyen de l'appareil de surveillance de l'isolement (61),
D) l'évaluation des courants de mesure acquis,
E) le courant de mesure de la surveillance de l'isolement de l'ensemble du réseau étant également utilisé pour la recherche de défauts d'isolement dans les circuits électriques individuels du réseau, et
**caractérisé en ce que** le procédé comprend en outre
F) la détermination et l'évaluation, à partir de l'évolution temporelle du courant de mesure de chaque transformateur de courant (64) et de la tension de mesure de l'appareil de surveillance de l'isolement (61), de la résistance d'isolement ohmique (69) et de la réactance capacitive (65) de chaque départ de réseau (79),
l'acquisition du courant de mesure (10) étant effectuée par au moins une corrélation des valeurs d'échantillonnage du courant de mesure,
les corrélations des valeurs d'échantillonnage du courant de mesure étant effectuées au moyen d'une oscillation sinusoïdale dont la fréquence correspond à la fréquence de la tension de mesure fₘ de la surveillance de l'isolement,
ou
l'acquisition du courant de mesure (10) étant effectuée par au moins deux corrélations des valeurs d'échantillonnage du courant de mesure, de préférence avec une oscillation cosinusoïdale et une oscillation sinusoïdale, les deux corrélations des valeurs d'échantillonnage du courant de mesure pouvant être synchronisées, et une valeur complexe du courant de mesure étant déterminée, dont l'angle est rapporté à la tension de mesure.

2. Procédé selon la revendication 2, qui comporte en outre une ou plusieurs des sous-étapes suivantes :
- prémagnétisation du noyau du transformateur de courant,
- réduction des influences perturbatrices à haute fréquence sur l'électronique de mesure,
- utilisation d'amplificateurs opérationnels à faible bruit dans l'électronique de mesure,
- mise en place d'une fonction passe-haut pour supprimer le bruit à basse fréquence,
- réduction de la largeur de bande afin de réduire l'influence du bruit sur l'acquisition du courant de mesure (10).

3. Procédé selon la revendication 1 ou 2, dans lequel la surveillance de l'isolement et la recherche de défauts d'isolement se déroulent simultanément.

4. Procédé selon l'une des revendications 1 à 3, dans lequel la surveillance de l'isolement et la recherche de défauts d'isolement sont effectuées lorsque le transformateur (81) est en circuit ou hors circuit.

5. Procédé selon l'une des revendications 1 à 4, dans lequel, dans le circuit secondaire (2) des transformateurs de courant (64), la résistance du cuivre (R_{cu}) (91) de la bobine secondaire (1) est compensée par une résistance négative.

6. Procédé selon la revendication 1, dans lequel la résistance d'isolement ohmique (69) et la réactance capacitive (65) et/ou l'impédance (67) de chaque départ de réseau (79) sont calculées, à l'aide de la règle du diviseur de courant, à partir du rapport des courants de mesure individuels au courant de mesure total.

7. Procédé selon l'une des revendications 1 à 6, dans lequel la surveillance de l'isolement et la recherche de défauts d'isolement dans les départs de réseau (79) sont effectuées en permanence lorsque le transformateur (81) est en circuit comme lorsqu'il est hors circuit.

8. Procédé selon l'une des revendications 1 à 7, dans lequel l'inductance différentielle (Lₛ) de la bobine secondaire (1) du transformateur de courant (64) est augmentée par une prémagnétisation.

9. Procédé selon l'une des revendications 1 à 8, dans lequel le noyau de transformateur de courant de la bobine secondaire (1) du transformateur de courant (64) est démagnétisé.

10. Procédé selon l'une des revendications 1 à 9, dans lequel l'inductance différentielle (Lₛ) de la bobine secondaire (1) du transformateur de courant (64) est déterminée par mesure de l'impédance (65) du circuit secondaire (2).

11. Procédé selon l'une des revendications 5 à 10, dans lequel un réglage du point zéro du circuit secondaire (2) du transformateur de courant différentiel et la compensation de la résistance du cuivre (R_{cu}) (91) de la bobine secondaire (1) sont effectués par le même régulateur proportionnel-intégral (95).

12. Procédé selon l'une des revendications 1 à 11, dans lequel l'évaluation des courants de mesure est effectuée à un emplacement central et les valeurs des courants de mesure sont transmises à l'emplacement central par des moyens de communication appropriés.

13. Dispositif de surveillance de l'isolement et de recherche de défauts d'isolement pour des réseaux d'alimentation électrique non mis à la terre sans générateur de courant d'essai, comprenant
- un appareil de surveillance de l'isolement (61) pouvant être disposé à un emplacement central du réseau d'alimentation électrique,
l'appareil de surveillance de l'isolement (61) étant conçu pour générer une tension de mesure permanente entre un conducteur du réseau (60) et la terre (80) et pour injecter un courant de mesure,
- au moins un transformateur de courant (64) pouvant être disposé dans chaque départ de réseau (79), de manière centralisée au niveau du point d'alimentation du réseau d'alimentation électrique (63), entre l'appareil de surveillance de l'isolement (61) et le premier départ de réseau (79), ledit transformateur de courant étant conçu pour l'acquisition temporelle de l'évolution du courant de mesure injecté par l'appareil de surveillance de l'isolement (61) et des courants de mesure partiels de l'appareil de surveillance de l'isolement (61) au niveau des départs de réseau (79), que le transformateur (81) soit en circuit ou hors circuit,
- au moins un appareil d'évaluation destiné à l'évaluation des courants de mesure acquis,
**caractérisé en ce que** l'appareil d'évaluation est configuré pour
utiliser le courant de mesure de la surveillance de l'isolement de l'ensemble du réseau également pour la recherche de défauts d'isolement dans les circuits électriques individuels du réseau, et
effectuer, à partir de l'évolution temporelle du courant de mesure de chaque transformateur de courant (64) et de la tension de mesure de l'appareil de surveillance de l'isolement (61), la détermination et l'évaluation de la résistance d'isolement ohmique (69) et de la réactance capacitive (65) de chaque départ de réseau (79),
l'acquisition du courant de mesure (10) étant effectuée par au moins une corrélation des valeurs d'échantillonnage du courant de mesure,
les corrélations des valeurs d'échantillonnage du courant de mesure étant effectuées au moyen d'une oscillation sinusoïdale dont la fréquence correspond à la fréquence de la tension de mesure fₘ de la surveillance de l'isolement,
ou
l'acquisition du courant de mesure (10) étant effectuée par au moins deux corrélations des valeurs d'échantillonnage du courant de mesure, de préférence avec une oscillation cosinusoïdale et une oscillation sinusoïdale, les deux corrélations des valeurs d'échantillonnage du courant de mesure pouvant être synchronisées, et une valeur complexe du courant de mesure étant déterminée, dont l'angle est rapporté à la tension de mesure.
